# EUROPEAN PATENT APPLICATION

(11) **EP 3 839 539 A1**
(43) Date of publication of application: **23.06.2021**
(21) Application number: 19217591.7
(22) Date of filing: 18.12.2019
(51) Int. Cl.: G01R 31/64, G01R 31/327

(54) **METHOD, SYSTEM AND APPARATUS FOR DIAGNOSING MALFUNCTION IN A POWER DISTRIBUTION UNIT**

(71) Applicant: Panasonic Intellectual Property Management Co., Ltd., Osaka-shi, Osaka 540-6207 (JP)
(72) Inventor: RICHTER, Max, 21337 Lüneburg (DE); MEINTS, Eike, 21337 Lüneburg (DE)
(74) Representative: Grünecker Patent- und Rechtsanwälte PartG mbB

(57) **Abstract**

The present subject matter at least refers the method for diagnosing-malfunction in a power distribution unit. The DC-link capacitor (208) is charged to a first potential by turning ON a first switching element (212), SE. The first SE (212) is connected in series with a resistor to define a pre-charge circuit for the DC- link capacitor (208). The DC-link capacitor (208) is discharged from the first potential through a discharge resistor (206) by turning ON a second switching element (210), SE. The discharge-resistor (206) is connected in series with the second SE (210) to define a discharge circuit. The DC-link capacitor (208) is charged to a second potential higher than the first potential. A DC-link voltage is monitored by a diagnose circuit connected to the pre-charge and discharge-circuit during said charging and discharging of the DC-link capacitor (208).

## Description

### TECHNICAL FIELD

The present subject matter relates to generally to power distribution units and, more particularly to pre-charging mechanism therein.

### BACKGROUND

A state of the art electric motor drive-device for driving an electric motor via an inverter has a smoothing-capacitor (i.e. a DC Link capacitor) provided in parallel with a DC power supply at the inverter input side. In an example, an electric motor driven vehicle such as a hybrid vehicle includes a drive motor, a high-voltage battery for supplying power to the drive motor, and an inverter. The smoothing capacitor or the DC link capacitor is provided between the inputs of the inverter to smooth voltage fluctuations and stabilize the operation of the inverter.

The smoothing capacitor serves to reduce the impedance of a main circuit and suppresses surge voltage, and also serves to absorb regenerative power in the case of abnormality and prevent overvoltage in the main circuit. One example of abnormal cases is a so-called load dump in which, while the electric motor is performing regenerative operation, input wiring of the inverter is disconnected due to vibration or the like, or a breaker provided on the input side fails, and thus connection between a smoothing capacitor on the Inverter input side and a DC power supply is opened. As may be understood, if the capacitance of the smoothing capacitor is reduced for the purpose of size reduction, increase in voltage caused by absorption of regenerative power in the case of abnormality becomes substantial, leading to overvoltage.

Another example scenario is wherein to rescue a driver in an event of car accident or vehicle maintenance for example, it is necessary to quickly discharge smoothing capacitor or the DC link capacitor). Such scenarios also remain prone to voltage surges and require overvoltage protection.

As a conventional technique for suppressing such overvoltage, an overvoltage protection device is provided which includes: a bypass resistance circuit interposed between terminals at an input part of an inverter; a relay interposed in series to the bypass resistance circuit and controlled, to be opened/closed; and control means for controlling the relay to make the bypass resistance circuit active when input voltage of the inverter is equal to or greater than reference voltage

In automotive applications the fast discharge circuit is necessitated to be designed with a high automotive safety integrity level (ASIL). Accordingly, there lies a need to timely and cost-effectively diagnose the health of the components at least in the discharge and ancillary circuits.

Moreover, there lies at least a need of protecting low and high voltage circuits from surge voltages.

### SUMMARY

This summary is provided to introduce a selection of concepts in a simplified format that is further described in the detailed description of the present disclosure. This summary is neither intended to identify key inventive concepts of the disclosure nor is it intended for determining the scope of the invention or disclosure.

In an implementation, the present subject matter provides a method for diagnosing-malfunction in a power distribution unit. The DC-link capacitor is charged to a first potential by turning ON a first switching element (SE). The first SE is connected in series with a resistor to define a pre-charge circuit for the DC- link capacitor.

The DC-link capacitor is discharged from the first potential through a discharge resistor by turning ON a second switching element (SE). The discharge-resistor is connected in series with the second SE to define a discharge circuit. The DC-link capacitor is charged to a second potential higher than the first potential. A DC-link voltage is monitored by a diagnose circuit connected to the pre-charge and discharge-circuit during said charging and discharging of the DC-link capacitor.

In another embodiment, the present subject matter illustrates an electronic-system for diagnosing malfunction within a power distribution unit. The system comprises a precharge circuit for charging a DC- link capacitor through a power-source and comprising a series connection between a switching element and a resistor. The pre-charge circuit is connected to the DC link and is operable in accordance with the steps of:
a) charge the DC-link capacitor to a first potential by turning ON the second SE;
b) discharge the DC- link capacitor from the first potential through a discharge resistor by turning ON another switching element (SE) connected in series to said discharge-resistor; and
c) charge the DC-link capacitor to a second potential higher than the first potential;

Further, a diagnose-circuit is provided within the electronic-system comprises a voltmeter configured for at-least monitoring the DC-link voltage during said operation of the pre-charge circuit.

The objects and advantages of the embodiments will be realized and achieved at-least by the elements, features, and combinations particularly pointed out in the claims. It is to be understood that both the foregoing general description and the following detailed description are representative and explanatory and are not restrictive of the invention, as claimed.

### BRIEF DESCRIPTION OF THE DRAWINGS

These and other features, aspects, and advantages of the present disclosure will become better understood when the following detailed description is read with reference to the accompanying drawings in which like characters represent like parts throughout the drawings, wherein:
FIG. 1 illustrates method steps in accordance with an embodiment of the present subject matter;
FIG. 2 illustrates a schematic-electronic system, in accordance with an embodiment of the present subject matter;
FIG. 3 illustrates the schematic-electronic system of Fig. 2 with additional details in accordance with an embodiment of the present subject matter;
FIG. 4 illustrates an example power-supply arrangement for the electronic system of Fig. 2, in accordance with an embodiment of the present subject matter;
FIG. 5 illustrates an example gate drive circuit for the power-supply arrangement as depicted in Fig. 4, in accordance with an embodiment of present subject matter;
FIG. 6 illustrates an example timing diagram depicting the pre-charge procedure and diagnosis , in accordance with embodiment of the present subject matter;

The elements in the drawings are illustrated for simplicity and may not have been necessarily been drawn to scale. Furthermore, in terms of the construction of the device, one or more components of the device may have been represented in the drawings by conventional symbols, and the drawings may show only those specific details that are pertinent to understanding the embodiments of the present disclosure so as not to obscure the drawings with details that will be readily apparent to those of ordinary skill in the art having benefit of the description herein.

### DETAILED DESCRIPTION OF SOME EXAMPLE EMBODIMENTS

For the purpose of promoting an understanding of the principles of the present disclosure, reference will now be made to the embodiment illustrated in the drawings and specific language will be used to describe the same. It will be understood that no limitation of the scope of the present disclosure is thereby intended, such alterations and further modifications in the illustrated system, and such further applications of the principles of the present disclosure as illustrated therein being contemplated as would normally occur to one skilled in the art to which the present disclosure relates.

The foregoing general description and the following detailed description are explanatory of the present disclosure and are not intended to be restrictive thereof.

Reference throughout this specification to "an aspect", "another aspect" or similar language means that a particular feature, structure, or characteristic described in connection with the embodiment is included in at least one embodiment of the present disclosure. Thus, appearances of the phrase "in an embodiment", "in another embodiment" and similar language throughout this specification may, but do not necessarily, all refer to the same embodiment.

The terms "comprises", "comprising", or any other variations thereof, are intended to cover a non-exclusive inclusion, such that a process or method that comprises a list of steps does not include only those steps but may include other steps not expressly listed or inherent to such process or method. Similarly, one or more devices or subsystems or elements or structures or components proceeded by "comprises ... a" does not, without more constraints, preclude the existence of other devices or other subsystems or other elements or other structures or other components or additional devices or additional subsystems or additional elements or additional structures or additional components.

Unless otherwise defined, all technical and scientific terms used herein have the same meaning as commonly understood by one of ordinary skill in the art to which this present disclosure belongs. The system, methods, and examples provided herein are illustrative only and not intended to be limiting.

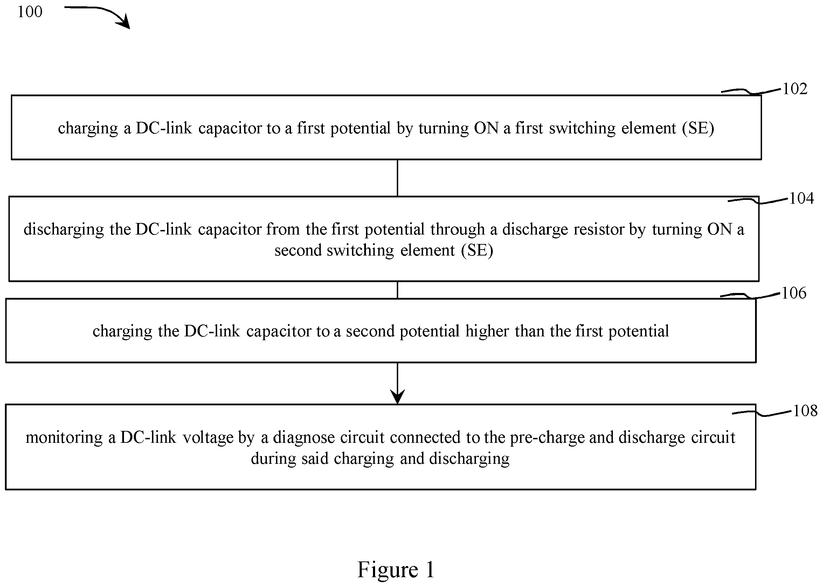

Figure 1 illustrates a method for diagnosing malfunction in a power distribution unit. The method comprises charging (step 102) a DC-link capacitor to a first potential by turning ON a first switching element (SE). The first SE is connected in series with a resistor to define a pre-charge circuit for the DC- link capacitor. The first SE is defined by one or more of an IGBT, a semiconductor transistor, a power MOSFET. The DC-link capacitor is discharged (step 104) from the first potential through a discharge circuit comprising a discharge-resistor by turning ON a second switching element (SE). The second SE may be defined by at least one of a thyristor, silicon control rectifier, and transistor. The discharge-resistor is connected in-series with the second SE to define a discharge circuit.

During said charging in step 102, a DC-link voltage is monitored (step 108) by a diagnose-circuit connected to the pre-charge circuit. During the charging of the DC-link capacitor to the first potential, the current and DC-link voltage are measured by the diagnose-circuit. Based thereupon, the diagnosis is made as follows:
a) In case the DC-link voltage and the current are detected as null, an alert is generated pertaining to malfunctioning of the first SE.
b) In case the DC link voltage is detected as null and the current is detected as substantially high, an alert pertaining to a short-circuited state of the second SE is generated.

During the discharging (step 104) of the DC-link capacitor from the first potential, the voltage of the DC-Link capacitor charged by the first potential is monitored (step 108) to diagnose an operation of the second SE. Such diagnosis of the operation of the second SE comprises ascertaining if the voltage of the DC-Link capacitor charged by the first potential is observed lower than a predetermined value. Such diagnosis of the operation of the second SE comprises generating an alert pertaining to the malfunctioning of the second SE if the voltage of the DC-Link capacitor charged by the first potential is observed as lower than a predetermined value.

Further, the method comprises charging (step 106) the DC-link capacitor to a second potential higher than the first potential. The voltage of DC-Link capacitor charged by the second potential is monitored (step 108) to diagnose an operation of the DC-link capacitor. The diagnosis of the operation of the DC-link capacitor comprises ascertaining if the voltage of the DC-Link capacitor charged by the second potential is observed lower than a predetermined value. The diagnosis of the operation of the DC link capacitor comprises generating an alert pertaining to the malfunctioning of the DC link capacitor if the voltage of the DC-Link capacitor charged by the second potential is observed lower than a predetermined value.

The method further comprises turning ON a positive relay before switching ON the first SE of the pre-charge circuit for charging the DC-Link capacitor to the first potential, the positive-relay is disposed in a positive power-path between the power source and the DC-Link capacitor. On the other hand, a negative relay is turned ON after charging the DC-Link capacitor to the second potential and before turning OFF the first SE of the pre-charge circuit. The negative-relay is disposed in a negative power-path between the power source and the DC-Link capacitor.

The method further comprises receiving logic-signals from a logic circuit for switching ON/OFF the first SE of the pre-charge circuit via a high voltage (HV) circuit. The high-voltage circuit is connected to an HV power supply and together with the logic circuit. During an open state of a pyro-switch connected to the logic circuit and the HV circuit, the backflow of current from the HV circuit to the logic circuit is prevented by at-least one diode provided within the HV circuit. The backflow of current is triggered by an open state of a pyro-switch connected to the logic circuit and the HV circuit.

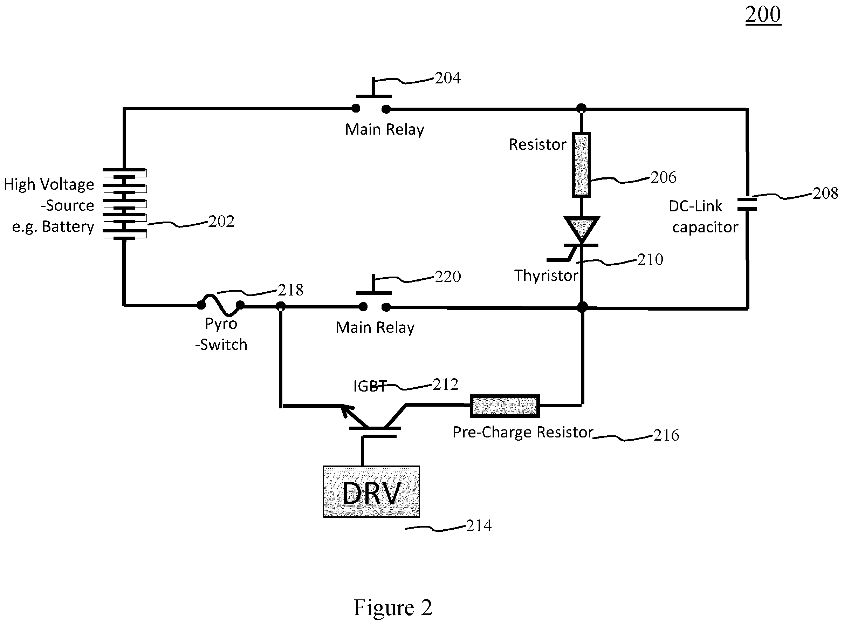

Figure 2 illustrates a schematic-architecture based on the method steps of Fig. 1, in accordance with an embodiment of the present subject matter. More specifically, Fig. 1 illustrates an electronic-system 200 for diagnosing malfunction within a power distribution unit. The electronic system 200 comprises a discharge-circuit connected between a power source 202 and a DC-link capacitor 208. The discharge-circuit is connected in parallel to the DC-link capacitor 208 and comprises a first switching element (SE) 210. A first-resistor 206 is connected in series with the first SE 210 and configured for facilitating discharge of DC-link capacitor 208 upon an ON state of the first SE 210. The discharge circuit comprises at least one of thyristor, silicon controlled rectifier, a semiconductor transistor acting as the first SE 210.

Further, a pre-charge circuit for the DC-link capacitor 208 comprises a series connection between a second SE 212 and a second resistor 216. The pre-charge circuit is connected to the DC link capacitor 208 and the first SE 210. The pre-charge circuit comprises one or more of a semiconductor transistor, IGBT, power MOSFET acting as the second SE 212.

The system 200 further comprises a positive-relay 204 disposed in a positive power-path between the power source 202 and the DC-Link capacitor 208. A negative-relay 220 is disposed in a negative power-path between the power source 202 and the DC-Link capacitor 208. A controller may be configured to turn ON the positive relay 204 before switching on the second SE 212 of the pre-charge circuit for charging the DC-Link capacitor 208 to the first potential. Further, said controller may be configured to turn ON the negative relay 220 after charging the DC-Link capacitor 208 to the second potential and before turning off the second SE 212 of the pre-charge circuit

Further, the system 200 comprises a pyro-switch 218 acting as a circuit-breaker between the DC-Link capacitor 208 and the power source 202. A gate drive circuit 214 is provided for driving the second SE 212 of the pre-charge circuit and connected to the pyroswitch 218.

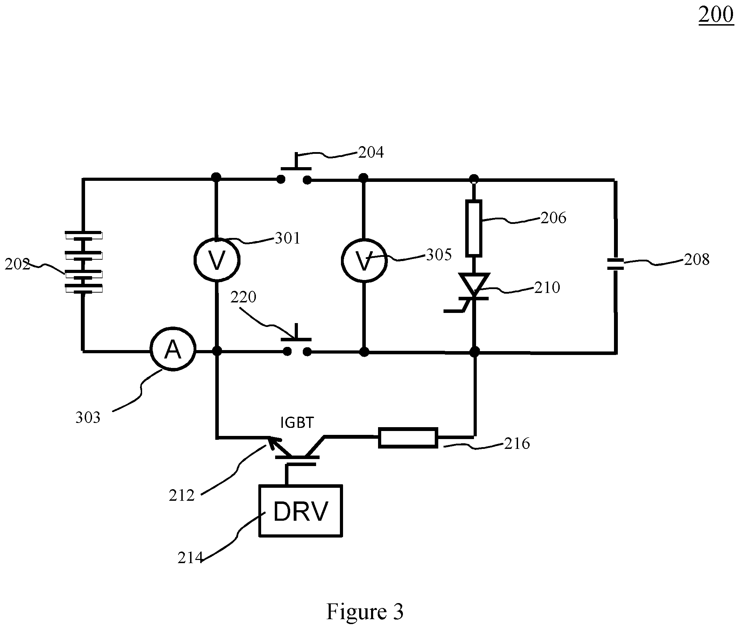

FIG. 3 illustrates example system implementation in accordance with an embodiment of the present subject matter. More specifically, the present figure illustrates a diagnose circuit forming a part of the electronic system as depicted in Fig. 2. The diagnose-circuit comprises a first voltage detector 301 provided between the power source 202 (or the battery 202) and positive relay 204 to monitor the voltage of battery 202. Another voltage detector 305 is provided to monitor the voltage during the charging/discharging of the DC-Link capacitor 208. Further, an ammeter 303 is configured for measuring current during the step of charging of the DC-Link capacitor 208.

The diagnose circuit is operable in accordance with the steps of:
a) Charge the DC-link capacitor 208 to a first potential by turning ON the SE 212 and thereafter discharge the DC- link capacitor 208 through the discharge resistor 206 by turning ON the SE 210;
b) Thereafter, charging the DC-link capacitor 208 to a second potential higher than the first potential; and
c) Monitoring the DC-link voltage during said operation of the pre-charge circuit.

In operation, at step 302, the positive main-relay 204 is switched ON to trigger the first pre-charge operation. For such purpose, the SE 212 or a Pre-charge IGBT 212 is switched ON, e.g. for less than 1 ms, and accordingly a pre-charging till an example voltage 50V is achieved within said duration of 1 ms. Following may be the example conditions as associated during said charging
a) In case the IGBT 212 is open, the current values as measured by ammeter 303 is null.
b) In case the IGBT 212 is operable but the SE 210 or the thyristor 210 is short, a high current is shown as detected through the ammeter 303.

As a part of safety measure during the short-circuit operation, the fast discharge resistor 206 and pre-charge resistor 216 are provided with a fuse-function.

As Step 304, the Pre-charge IGBT 212 is switched OFF and the DC-Link voltage is diagnosed through the voltmeter 305. In case of the IGBT 212 having remained open, the DC-link capacitor 208 through the voltmeter 305 depicts either null voltage or a value marginally above null, thereby confirming the non-accomplishment of the pre-charge operation or an inaccurate pre-charge operation. In case of the thyristor 210 having been short, the DC-link capacitor 208 discharges from the charged state quickly and the voltmeter 305 depicts either null voltage or a value marginally above null, thereby confirming the accomplishment of the pre-charge operation however due to the shorted thyristor.

In other scenario, wherein the pre-charge has been successful, the DC-link voltage as recorded by the voltmeter 305 remains as 50V. Accordingly, 50V may be acknowledged as the diagnosis for detecting "Thyristor" 210 and IGBT 212 as operating normally. Otherwise, null DC link voltage is recorded as a part of abnormal operation, i.e. short state of the thyristor 210 or the open state of IGBT 212.

At step 306, the thyristor 210 is switched ON to discharge the DC-link capacitor 208 to 0V. The thyristor 210 switches-off by itself upon completion of the said first discharge. In case the thyristor had remained open despite switching it ON and is accordingly faulty, then no discharge takes place and DC link voltage remains recorded as 50V only or a value lesser than 50V by a pre-determined value. In case of successful-discharge of the capacitor 208 due to normal operation of the thyristor 210 (i.e. closure of the thyristor 210 upon switch ON), the voltmeter records "0V" or a value marginally above "0V". Accordingly, "0V" may be acknowledged as diagnosis for normal operation of thyristor 210.

Steps 302 to 306 may be referred as mini-precharge operation that enable diagnosis of the thyristor 210 once per drive cycle. Overall, at least based on aforesaid it may be understood that the diagnose-circuit is configured to generate an alert pertaining to malfunctioning of the IGBT 212 (i.e. open state of IGBT 212) upon detecting the DC-link voltage and the current being null. Moreover, the diagnose-circuit is configured to generate an alert pertaining to a short-circuited state of the thyristor 210 upon detecting the DC link voltage being null and the current being substantially high. Furthermore, the diagnose-circuit is configured to generate an alert pertaining to malfunctioning of the thyristor 210 (i.e. open state of the thyristor despite being switched ON to discharge the DC link capacitor), when the voltage of the DC-Link capacitor 208 charged by the first potential is observed lower than a predetermined value.

In case the pre-charge IGBT 212 is 'short', the same may be externally detected by state of art measures, e.g. saturation voltage-measurement in a corresponding gate driver or gate-surveillance in gate-driver circuit 214.

As step 308, the pre-charge IGBT 212 is again switched ON to trigger a second pre-charge or a complete pre-charge of DC link capacitor 208 (i.e. to a second potential say about 1000V) to a value in accordance with the state of the art operation. Accordingly, the DC-Link voltage of charged capacitor 208 is recorded by the voltmeter during the charging operation. In case of the recorded voltage as being significantly below the second potential, the DC link capacitor 208 is adjudicated as faulty. To put it differently, the voltmeter 305 or the voltage detector monitors the voltage of the DC-Link capacitor 208 charged by the second potential and thereby generates an alert related to malfunctioned DC-link capacitor 208 when the voltage of the DC-Link capacitor 208 charged by the second potential is lower than a predetermined value.

At step 310, as a matter of concluding the pre-charge operation, the negative Main Relay 220 is turned ON first and thereafter the pre-charge IGBT 212 is switched OFF. Due to slow switching of the negative relay 220, a voltage-gap is reduced by maintaining the IGBT 212 in ON state while the negative relay 220 is switching from OFF state to ON state, thereby resulting in less stress on the main relay (negative 220 and positive 204) and an increased-lifetime.

In an implementation, as a safety measure, when the energy in the fast-discharge 206 and/or precharge resistor 216 exceeds a given-limit, the resistor behaves as an electrical-fuse and opens the circuit.

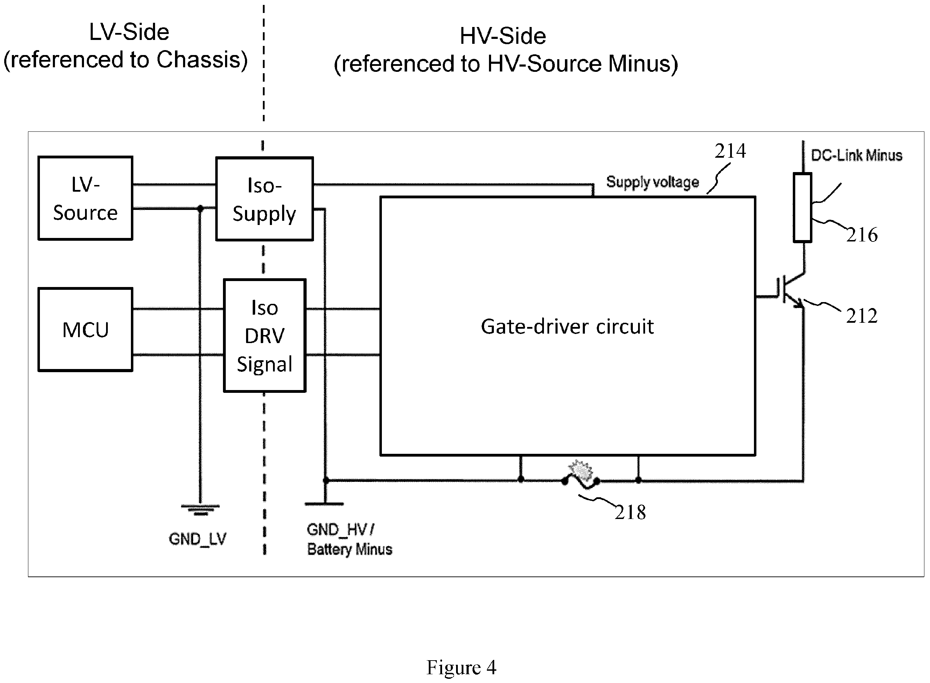

FIG. 4 illustrates an example power-supply arrangement for the electronic system of Fig. 2, in accordance with an embodiment of the present subject matter. The power-supply arrangement comprises a central Low voltage (LV) source to render a high voltage supply of about 15 V to a gate-driver circuit 214 through an isolated power-supply (i.e. transformer arrangement) connected to the LV source. Likewise, a control-signal generated by the microcontroller MCU is communicated by another isolated supply arrangement to the gate driver circuit 214.

In an example, the isolation may be defined as the electrical separation between the power supply and control signal on one hand, and the gate driver circuit on other hand to enable absence of a direct conduction path available there-between. Signal and/or power can still pass between isolated circuits using inductive, capacitive, or optical methods. Accordingly, isolation may be necessary for functional purposes and also renders safety requirement for gate drivers. Further, as another safety measure, a state of the art pyro switch 218 is provided to disconnect the gate driver circuit 214, the low voltage circuit comprising the low voltage source and MCU, and the DC- link capacitor 208 from the power supply or battery in case of accident.

The MCU may be one or more general processors, digital signal processors, application specific integrated circuits, field programmable gate arrays, servers, networks, digital circuits, analog circuits, combinations thereof, or other now known or later developed devices for analysing and processing data. The MCU may implement a software program, such as code generated manually (i.e., programmed).

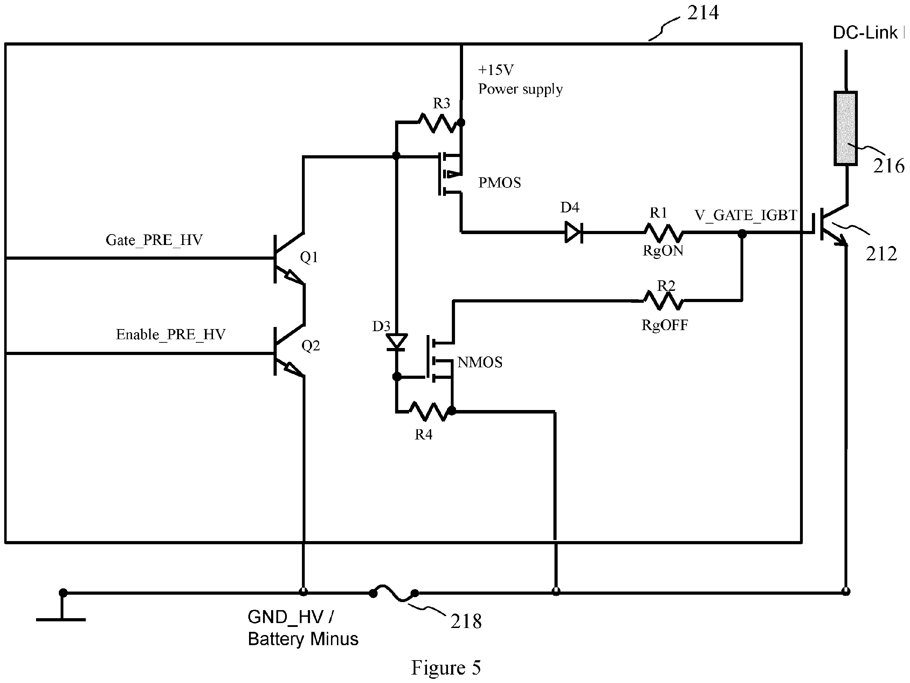

FIG. 5 illustrates an example gate drive circuit 214 for the power-supply arrangement as depicted in Fig. 4, in accordance with an embodiment of present subject matter;

The gate driver circuit 214 may be provided in a push-pull configuration such that when both Gate_PRE_HV and Enable_PRE_HV are high or logical 1, then the PMOS may be powered ON and pulls the V_Gate_IGBT to logical '1' or power supply +15V, thereby switching ON the IGBT 212. When either one of Gate_PRE_HV and Enable_PRE_HV is low or logical 0, then the NMOS may be powered ON and pushes the V_Gate_IGBT to logical '0' or Ground, thereby switching OFF the IGBT 212.

In an implementation, a high-voltage (HV) circuit may be defined by the 15 V power supply connected to the PMOS and NMOS, and the connection of the gate driver circuit 214 with the gate of the pre-charge IGBT 212. Such HV circuit forming a part of the gate driver circuit 214 is connected to a right terminal of the pyro switch 218.

A low voltage circuit within the gate driver circuit 214 may be defined by the logic circuit Q1, Q2 connected to the MCU to receive logic signals for switching ON/OFF the IGBT 212 of the pre-charge circuit through the high voltage circuit. Such HV circuit forming a part of the gate driver circuit 214 is defined connected to a left terminal of the pyro switch 218.

Within the HV circuit of the gate driver circuit 214, at least one diode (D4, D3) is provided to prevent backflow of current from the HV circuit to the logic circuit upon an open state of the pyroswitch 218 and thereby protect the gate-drive circuit 214. More specifically, in case of pyroswitch breaking open, the right terminal of the pyroswitch 218 may be 1000 V while the left terminal is rendered at 0 voltage. Due to inductance, the voltage in reverse direction increases, thereby leading to high voltage surges and an ensuing backflow of current within the HV circuit of the gate driver circuit 214 and in turn endangering the LV circuit or the logic circuit Q1, Q2 within the gate driver circuit 214.

The present gate drive circuit 214 prevents the break between such HV and LV circuit. For example, the diodes D3 and D4 prevent backflow when the pyro switch 218 opens and accordingly protect the transistors Q1 and Q2 of the logic circuit and resistor R3 connected to the power supply of 15 volts.

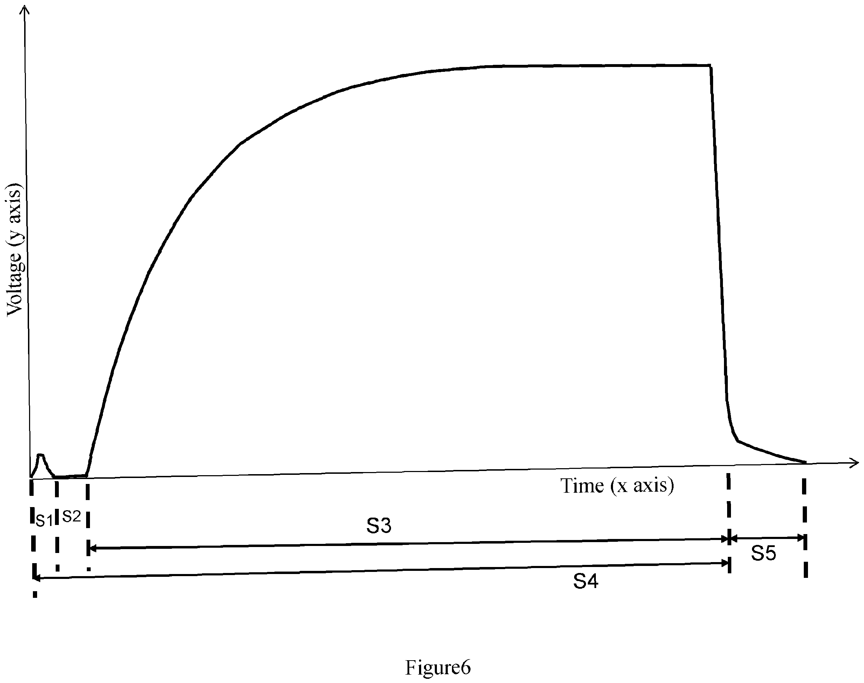

FIG. 6 illustrates an example timing diagram depicting the pre-charge procedure and diagnosis, in accordance with embodiment of the present subject matter. More specifically, the present figure at least illustrate a pre-charge procedure referring the diagnosis by "Minipre-charge" as corresponding to the steps 302 to 310 of Fig. 3. The *y axis* represent the voltage and *x axis* refer the time (for example, in microseconds) as expended during the pre-charging and discharging of the DC- link capacitor 208.

Step S1 corresponds to the steps 302 to 304 and directed to pre-charging the capacitor 208 to approximately 50V

Step S2 corresponds to the step 306 and directed to "discharging" the DC-Link capacitor 208 through the discharge resistor 206 and the thyristor 210 with current below 100A.

Step S3 corresponds to steps 308 and 310 and directed to a second precharge or a full pre-charge to about 1000V.

Step S4 represents a combination of S1 to S3 and thereby denotes a complete precharge as achieved within a target-duration (say 300ms). The target duration includes the diagnosis of thyristor 210 and the IGBT 212 once per driving cycle, and the second precharge defined by the actual-pre-charge.

Step S5 represents a Fast Discharge within 30ms from 1000v to below 12V. In an example, the fast discharge may be defined by recuperation, and a maximum current below 2kA

The diagnosis circuit as referred in the present subject matter for pre-charge and discharge circuits in power distribution-unit's application at-least renders a high safety level that can be reached with the present subject matter's diagnosis-function. This at-least facilitates a high automotive safety integrity level (ASIL) in automotive-applications having a fast capacitor-discharge circuit. Furthermore, the gate drive circuit 214 for driving the precharge circuit of the present subject matter additionally provides a special gate-driver circuit 214 for the IGBT to protect the low voltage circuit or logic circuit forming a part of the gate drive circuit 214 from surge voltages when the pyro-switch 208 opens.

Last but not the least, the pre-charge and discharge circuit in accordance with present subject matter employ safe, simpler, small, low cost, SMD components such as IGBT and thyristor based semiconductor components.

Terms used in this disclosure and especially in the appended claims (e.g., bodies of the appended claims) are generally intended as "open" terms (e.g., the term "including" should be interpreted as "including, but not limited to," the term "having" should be interpreted as "having at least," the term "includes" should be interpreted as "includes, but is not limited to," etc.).

Additionally, if a specific number of an introduced claim recitation is intended, such an intent will be explicitly recited in the claim, and in the absence of such recitation, no such intent is present. For example, as an aid to understanding, the following appended claims may contain usage of the introductory phrases "at least one" and "one or more" to introduce claim recitations. However, the use of such phrases should not be construed to imply that the introduction of a claim recitation by the indefinite articles "a" or "an" limits any particular claim containing such introduced claim recitation to embodiments containing only one such recitation, even when the same claim includes the introductory phrases "one or more" or "at least one" and indefinite articles such as "a" or "an" (*e.g*., "a" and/or "an" should be interpreted to mean "at least one" or "one or more"); the same holds true for the use of definite articles used to introduce claim recitations.

In addition, even if a specific number of an introduced claim recitation is explicitly recited, those skilled in the art will recognize that such recitation should be interpreted to mean at least the recited number (e.g., the bare recitation of "two recitations," without other modifiers, means at least two recitations, or two or more recitations). Furthermore, in those instances where a convention analogous to "at least one of A, B, and C, etc." or "one or more of A, B, and C, etc." is used, in general such a construction is intended to include A alone, B alone, C alone, A and B together, A and C together, B and C together, or A, B, and C together, etc. For example, the use of the term "and/or" is intended to be construed in this manner.

Further, any disjunctive word or phrase presenting two or more alternative terms, whether in the description of embodiments, claims, or drawings, should be understood to contemplate the possibilities of including one of the terms, either of the terms or both terms. For example, the phrase "A or B" should be understood to include the possibilities of "A" or "B" or "A and B."

All examples and conditional language recited in this disclosure are intended for pedagogical objects to aid the reader in understanding the invention and the concepts contributed by the inventor to furthering the art and are to be construed as being without limitation to such specifically recited examples and conditions. Although embodiments of the present disclosure have been described in detail, it should be understood that various changes, substitutions, and alterations could be made thereto without departing from the spirit and scope of the present disclosure.

## Claims

1. A method for diagnosing malfunction in a power distribution unit, said method comprising:
charging a DC-link capacitor to a first potential by turning ON a first switching element (SE), said first SE connected in series with a resistor to define a pre-charge circuit for the DC- link capacitor;
discharging the DC-link capacitor from the first potential through a discharge resistor by turning ON a second switching element (SE), said discharge-resistor connected in series with the second SE to define a discharge circuit;
charging the DC-link capacitor to a second potential higher than the first potential; and
monitoring a DC-link voltage by a diagnose circuit connected to the pre-charge and discharge circuit during said charging and discharging of the DC-link capacitor.

2. The method as claimed in claim 1, wherein said monitoring comprises:
monitoring the voltage of the DC-Link capacitor charged by the first potential to diagnose an operation of the second SE, said second SE defined by at least one of a thyristor, silicon control rectifier, transistor.

3. The method as claimed in claim 2, wherein said diagnosis of the operation of the second SE comprises ascertaining if the voltage of the DC-Link capacitor charged by the first potential is observed lower than a predetermined value.

4. The method according to any claim 2 to 3, wherein said diagnosis of the operation of the second SE comprises generating an alert pertaining to the malfunctioning of the second SE if the voltage of the DC-Link capacitor charged by the first potential is observed as lower than a predetermined value.

5. The method according to any claims 1 to 4, wherein said monitoring comprises:
monitoring the voltage of the DC-Link capacitor charged by the second potential to diagnose an operation of the DC-link capacitor.

6. The method as claimed in claim 5, wherein said diagnosis of the operation of the DC-link capacitor comprises ascertaining if the voltage of the DC-Link capacitor charged by the second potential is observed lower than a predetermined value.

7. The method according to any claims 5 to 6, wherein said diagnosis of the operation of the DC link capacitor comprises generating an alert pertaining to the malfunctioning of the DC link capacitor if the voltage of the DC-Link capacitor charged by the second potential is observed lower than a predetermined value.

8. The method according to claims 1 to 7, further comprises:
measuring current during the step of charging of the DC-link capacitor to the first potential by the diagnose-circuit and enabling performance of at least one of:
a) detecting the DC-link voltage and the current being null and thereby generating an alert pertaining to malfunctioning of the first SE, said first SE defined by one or more of an IGBT, a semiconductor transistor, a power MOSFET; and
b) detecting the DC link voltage being null and the current being substantially high for generating an alert pertaining to a short-circuited state of the second SE.

9. The methodaccording to claims 1 to 8, further comprises:
turning ON a positive relay before switching ON the first SE of the pre-charge circuit for charging the DC-Link capacitor to the first potential, said positive-relay disposed in a positive power-path between the power source and the DC-Link capacitor.

10. The method as claimed in claim 1, further comprising
turning ON a negative relay after charging the DC-Link capacitor to the second potential and before turning off the first SE of the pre-charge circuit, said negative-relay disposed in a negative power-path between the power source and the DC-Link capacitor.

11. The method according to claims 1 to 10, further comprising:
receiving logic signals from a logic circuit for switching ON/OFF the first SE of the pre-charge circuit via a high voltage (HV) circuit, said high-voltage circuit connected to an HV power supply; and
preventing backflow of current from the HV circuit to the logic circuit by at least one diode provided within the HV circuit, said backflow of current being triggered by an open state of a pyro-switch connected to the logic circuit and the HV circuit.

12. An electronic-system for diagnosing malfunction within a power distribution unit, said system comprising:
i) a discharge-circuit connected between a power source and a DC-link capacitor, said discharge circuit connected parallel to a DC-link capacitor and comprising:
a first switching element (SE); and
a first-resistor connected in series with the first SE for facilitating discharge of DC-link capacitor upon an ON state of the first SE;
ii) a pre-charge circuit for the DC-link capacitor comprising a series connection between a second SE and a second resistor, said pre-charge circuit connected to the DC link capacitor and the first SE and operable in accordance with the steps of:
a) charge the DC-link capacitor to a first potential by turning ON the second SE and thereafter discharge the DC- link capacitor through the discharge resistor by turning ON the first SE; and
b) charge the DC-link capacitor to a second potential higher than the first potential; and
iii) a diagnose-circuit for monitoring the DC-link voltage during said operation of the pre-charge circuit.

13. The system as claimed in claim 12, wherein:
said discharge circuit comprises at least one of thyristor, silicon controlled rectifier, a semiconductor transistor acting as the first SE; and
said pre-charge circuit comprises one or more of a semiconductor transistor, IGBT, power MOSFET acting as the second SE.

14. The system as claimed in claim 13, wherein the diagnose-circuit comprises:
a voltage detector to monitor the voltage of the DC-Link capacitor charged by the first potential, said diagnose circuit configured to generate an alert pertaining to malfunctioning of the thyristor when the voltage of the DC-Link capacitor charged by the first potential is observed lower than a predetermined value.

15. The system as claimed in claim 13, wherein the diagnose-circuit comprises a voltage detector to monitor voltage of the DC-Link capacitor and an ammeter for measuring current during the step of charging of the DC-Link capacitor to the first potential, wherein the diagnose circuit is configured to performing at least one of:
a) detecting the DC-link voltage and the current being null and thereby generating an alert pertaining to malfunctioning of the IGBT;
c) detecting the DC link voltage being null and the current being substantially high for generating an alert pertaining to a short-circuited state of the thyristor.

16. The system according to claims 12 to 15, wherein the diagnose-circuit comprises a voltage detector to monitor the voltage of the DC-Link capacitor charged by the second potential and thereby generate an alert when the voltage of the DC-Link capacitor charged by the second potential is lower than a predetermined value.

17. The system according to claims 12 to 16, further comprising:
a positive-relay disposed in a positive power-path between the power source and the DC-Link capacitor; and
a controller to turn ON the positive relay before switching on the second SE of the pre-charge circuit for charging the DC-Link capacitor to the first potential.

18. The system according to claims 12 to 17, further comprising
a negative-relay disposed in a negative power-path between the power source and the DC-Link capacitor; and
a controller to turn ON the negative relay after charging the DC-Link capacitor to the second potential and before turning off the second SE of the pre-charge circuit

19. The system according to claims 12 to 18, further comprising:
a pyro-switch acting as a circuit-breaker between the DC-Link capacitor and the battery;
and
a gate-drive circuit for driving the second SE of the pre-charge circuit and connected to the pyro-switch, said gate drive circuit comprising:
a high-voltage (HV) circuit connected to the power supply;
a logic circuit connected to a controller to receive logic signals for switching ON/OFF the second SE of the pre-charge circuit through the high voltage circuit;
at least one diode provided within the HV circuit to prevent backflow of current from the HV circuit to the logic circuit upon an open state of the pyro-switch and thereby protect the gate-drive circuit.
